# EUROPEAN PATENT APPLICATION

(11) **EP 3 863 048 A1**
(43) Date of publication of application: **11.08.2021**
(21) Application number: 20159326.6
(22) Date of filing: 25.02.2020
(51) Int. Cl.: H01L 23/495

(54) **PACKAGE STRUCTURES**

(30) Priority: 10.02.2020 US 202016786139
(71) Applicant: Delta Electronics, Inc., Taoyuan City 33341 (TW)
(72) Inventor: LEE, Peng Hsin, Taoyuan City (TW)
(74) Representative: 2K Patentanwälte Blasberg Kewitz & Reichel

(57) **Abstract**

A package structure is provided. The package structure includes a leadframe including a first portion and a second portion. The first portion includes a first base part and a plurality of first extended parts connected to the first base part. The second portion includes a second base part and a plurality of second extended parts connected to the second base part. The first extended parts and the second extended parts are arranged in such a way that they alternate with each other. In the package structure, a chip is disposed on a part of the first extended parts of the first portion and the second extended parts of the second portion of the leadframe.

## Description

### TECHNICAL FIELD

The invention relates to a package structure, and more particularly to a package structure with a comb-like leadframe.

### BACKGROUND

In a planar power component, a metal structure in the chip is required for collecting current, and then solder balls or wires lead the current to a leadframe or a substrate.

However, the turn-on time can be put out of synchronization by the metal structure in the chip being too thin, by the current that can be carried being limited, and by there being a voltage difference on the metal structure.

Therefore, development of a package structure capable of achieving uniform and stable current density and voltage during operation of the component is desirable.

### SUMMARY

In accordance with one embodiment of the invention, a package structure is provided. The package structure includes a leadframe including a first portion and a second portion opposite to the first portion. The first portion includes a first base part and a plurality of first extended parts connected to the first base part. The second portion includes a second base part and a plurality of second extended parts connected to the second base part. The first extended parts and the second extended parts are arranged in such a way that they alternate with each other. In the package structure, a chip is disposed on a part of the first extended parts of the first portion and the second extended parts of the second portion of the leadframe.

In some embodiments, the leadframe is made of metal. In some embodiments, the first portion and the second portion are comb-like structures. In some embodiments, the first extended parts of the first portion extend towards the second base part of the second portion, and the second extended parts of the second portion extend towards the first base part of the first portion. In some embodiments, the first extended parts of the first portion and the second extended parts of the second portion are coplanar.

In some embodiments, there is a first distance between the first extended part of the first portion and the second base part of the second portion. In some embodiments, there is a second distance between the first base part of the first portion and the second base part of the second portion. In some embodiments, the second distance is greater than or equal to three times the first distance. In some embodiments, the first distance is in a range from 100µm to 500µm.

In some embodiments, the first extended part of the first portion and the second extended part of the second portion have a first thickness. In some embodiments, the first base part of the first portion and the second base part of the second portion have a second thickness. In some embodiments, the second thickness is greater than or equal to two times the first thickness. In some embodiments, the difference between the second thickness and the first thickness is greater than or equal to 100µm. In some embodiments, the second thickness is in a range from 200µm to 400µm.

In some embodiments, the first extended part of the first portion has a bottom portion connected to the first base part and a top portion towards the second base part of the second portion, and the first extended part has a width which decreases gradually from the bottom portion to the top portion of the first extended part. In some embodiments, the first extended part of the first portion has a length and an average width, and the length is greater than or equal to three times the average width.

In some embodiments, the chip is disposed on a part of the first extended parts of the first portion and the second extended parts of the second portion via solder balls. In some embodiments, the chip is disposed on a part of the first extended parts of the first portion and the second extended parts of the second portion via copper pillars. In some embodiments, the chip is disposed on a part of the first extended parts of the first portion and the second extended parts of the second portion via solder paste, silver paste or a solder bar.

In some embodiments, a part of the first base part of the first portion further extends towards the second base part of the second portion to a position which is under a part of the first extended part of the first portion. In some embodiments, there is a third distance between the first base part of the first portion and the second base part of the second portion. In some embodiments, the third distance is greater than or equal to three times the first distance.

In some embodiments, the package structure further includes an encapsulation material covering the chip and a part of the leadframe, exposing sidewalls and bottoms of the first base part of the first portion and the second base part of the second portion of the leadframe.

In the present invention, a package structure with a specific comb-like leadframe is provided. Some appropriate dimensions and structure configurations of the leadframe are considered. For example, the distance between the first base part and the second base part is greater than or equal to about three times the distance between the first extended part and the second base part, or the thickness of the base part is greater than or equal to about two times the thickness of the extended part, or the extended part has the shape of trapezoid. When the distance between the first extended part and the second base part is less than 100µm, the insulation distance is insufficient. When the distance between the first extended part and the second base part is greater than 500µm, the size of the chip will exceed the range of the extended part, affecting the current conduction. When the thickness of the extended part is too thick, there is a risk of exposing the extended parts from the encapsulation material. In addition, the trapezoidal extended part improves the uniformity of the current conduction. When current is collected along the chip, it is no longer conducted only through the metal structure in the chip, but is the "extended part" combined with the metal structure. The total cross-sectional area for current conduction is increased by disposing the chip on the extended parts protruding from the base part of the comb-like leadframe which further increases the carrying current. The increase of the cross-sectional area also reduces the resistance value simultaneously, so that when the current flows through it, the voltage difference generated is reduced, achieving uniform and stable current density and voltage during component operation.

A detailed description is given in the following embodiments with reference to the accompanying drawings.

### BRIEF DESCRIPTION OF THE DRAWINGS

The invention can be more fully understood by reading the subsequent detailed description and examples with references made to the accompanying drawings, wherein:
FIG. 1 is a cross-sectional view of a package structure in accordance with one embodiment of the invention;
FIG. 2 is a stereoscopic view of a leadframe of a package structure in accordance with one embodiment of the invention;
FIG. 3 is a top view of a leadframe of a package structure in accordance with one embodiment of the invention;
FIG. 4 is a top view of a leadframe of a package structure in accordance with one embodiment of the invention;
FIG. 5 is a cross-sectional view of a package structure in accordance with one embodiment of the invention; and
FIG. 6 is a cross-sectional view of a package structure in accordance with one embodiment of the invention.

### DETAILED DESCRIPTION

The following description is of the best-contemplated mode of carrying out the invention. This description is made for the purpose of illustrating the general principles of the invention and should not be taken in a limiting sense. The scope of the invention is determined by reference to the appended claims.

In order to improve the uniformity and stability of current density and voltage of a power component during operation, the invention provides a package structure with a comb-like leadframe. The total cross-sectional area for current conduction can thus be increased by disposing a power component on extended parts protruding from a base part of the comb-like leadframe to achieve uniform and stable current density and voltage during component operation.

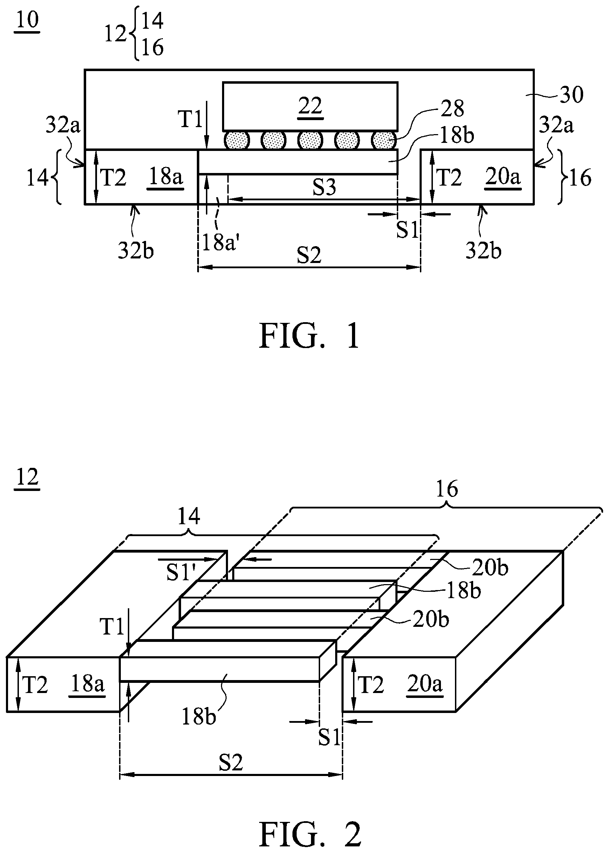

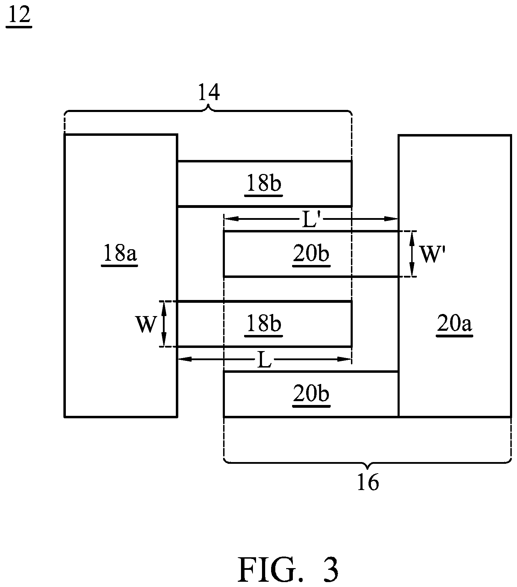

Referring to FIGS. 1, 2 and 3, in accordance with one embodiment of the invention, a package structure 10 is provided. FIG. 1 is a cross-sectional view of the package structure 10. FIG. 2 is a stereoscopic view of a leadframe of the package structure 10. FIG. 3 is a top view of a leadframe of the package structure 10.

As shown in FIGS. 1 and 2, the package structure 10 includes a leadframe 12 including a first portion 14 and a second portion 16 opposite to the first portion 14. The first portion 14 includes a first base part 18a and a plurality of first extended parts 18b, for example two first extended parts 18b, connected to the first base part 18a. The second portion 16 includes a second base part 20a and a plurality of second extended parts 20b, for example two second extended parts 20b, connected to the second base part 20a. In accordance with various product requirements, the number of extended parts may vary in the present invention, for example there may be three, four, or more, as long as there are at least two. The first extended parts 18b and the second extended parts 20b are arranged in such a way that they alternate with each other. In the package structure 10, a chip 22 is disposed on a part of the first extended parts 18b of the first portion 14 and the second extended parts 20b of the second portion 16 of the leadframe 12. In some embodiments, the chip 22 includes power components, for example high-power components.

In some embodiments, the leadframe 12 is made of metal, such as copper or another appropriate metal material. In FIG. 2, the first portion 14 and the second portion 16 are comb-like structures. The first extended parts 18b of the first portion 14 extend towards the second base part 20a of the second portion 16. The second extended parts 20b of the second portion 16 extend towards the first base part 18a of the first portion 14. The first extended parts 18b of the first portion 14 and the second extended parts 20b of the second portion 16 are coplanar.

In FIG. 2, there is a first distance S1 between the first extended part 18b of the first portion 14 and the second base part 20a of the second portion 16. There is a second distance S2 between the first base part 18a of the first portion 14 and the second base part 20a of the second portion 16. In some embodiments, the second distance S2 is greater than or equal to about three times the first distance S1. In some embodiments, the first distance S1 is in a range from about 100µm to about 500µm. Similarly, there is a first distance S1' between the second extended part 20b of the second portion 16 and the first base part 18a of the first portion 14. The second distance S2 is greater than or equal to about three times the first distance S1'. In some embodiments, the first distance S1' is in a range from about 100µm to about 500µm.

In FIG. 2, the first extended part 18b of the first portion 14 and the second extended part 20b of the second portion 16 have a first thickness T1. The first base part 18a of the first portion 14 and the second base part 20a of the second portion 16 have a second thickness T2. In some embodiments, the second thickness T2 is greater than or equal to about two times the first thickness T1. In some embodiments, the difference between the second thickness T2 and the first thickness T1 is greater than or equal to about 100µm. In some embodiments, the second thickness T2 is in a range from about 200µm to about 400µm.

Referring to FIG. 3, the first extended part 18b has a length L and a width W, and the length L is greater than or equal to about three times the width W. Similarly, the second extended part 20b has a length L' and a width W', and the length L' is greater than or equal to about three times the width W'. In FIG. 3, the first extended part 18b and the second extended part 20b are in the shape of a rectangle.

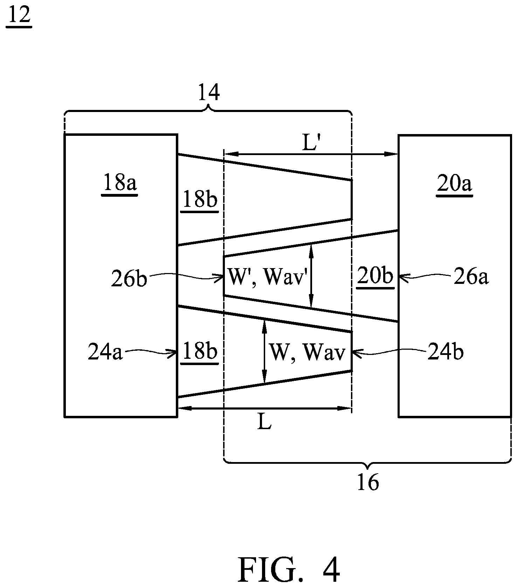

In some embodiments, the first extended part 18b and the second extended part 20b being another appropriate shape, such as the shape of trapezoid, is also applicable in the present invention, as shown in FIG. 4. In FIG. 4, the first extended part 18b of the first portion 14 has a bottom portion 24a connected to the first base part 18a and a top portion 24b towards the second base part 20a of the second portion 16. The first extended part 18b has a width W which decreases gradually from the bottom portion 24a to the top portion 24b of the first extended part 18b. The first extended part 18b of the first portion 14 has a length L and an average width Wav, and the length L is greater than or equal to about three times the average width Wav. Similarly, the second extended part 20b of the second portion 16 has a bottom portion 26a connected to the second base part 20a and a top portion 26b towards the first base part 18a of the first portion 14. The second extended part 20b has a width W' which decreases gradually from the bottom portion 26a to the top portion 26b of the second extended part 20b. The second extended part 20b of the second portion 16 has a length L' and an average width Wav', and the length L' is greater than or equal to about three times the average width Wav'.

In FIG. 1, the chip 22 is disposed on a part of the first extended parts 18b of the first portion 14 and the second extended parts 20b of the second portion 16 via solder balls 28. In FIG. 1, the solder balls 28 are first formed on the chip 22 by, for example electroplating. The reverse chip 22 is then attached on the first extended parts 18b of the first portion 14 and the second extended parts 20b of the second portion 16 by the solder balls 28 using the flip chip technology.

In FIG. 1, in some embodiments, a part of the first base part 18a of the first portion 14 further extends towards the second base part 20a of the second portion 16 to form an extending portion 18a' which is under a part of the first extended part 18b of the first portion 14. In FIG. 1, there is a third distance S3 between the extending portion 18a' of the first base part 18a of the first portion 14 and the second base part 20a of the second portion 16. In some embodiments, the third distance S3 is greater than or equal to about three times the first distance S1.

In FIG. 1, the package structure 10 further includes an encapsulation material 30 covering the chip 22 and a part of the leadframe 12, exposing sidewalls 32a and bottoms 32b of the first base part 18a of the first portion 14 and the second base part 20a of the second portion 16 of the leadframe 12.

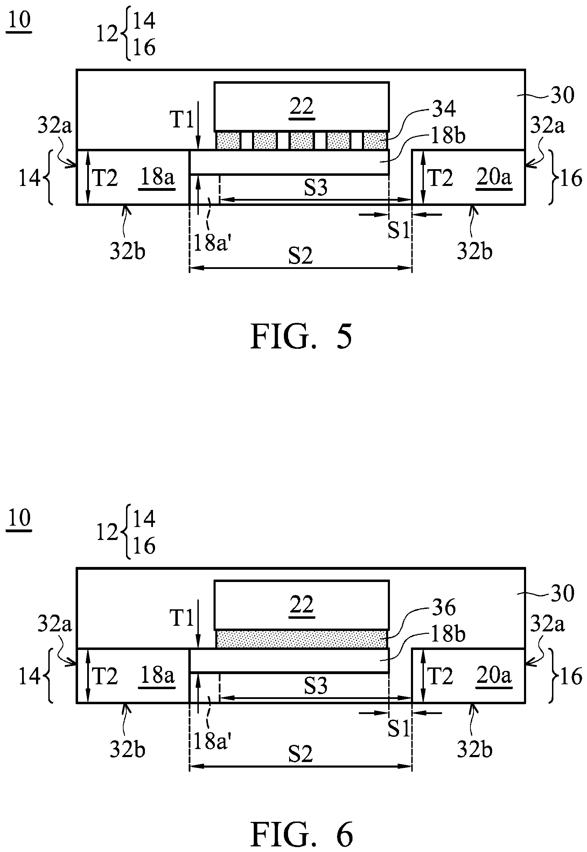

Referring to FIGS. 5, 2 and 3, in accordance with one embodiment of the invention, a package structure 10 is provided. FIG. 5 is a cross-sectional view of the package structure 10. FIG. 2 is a stereoscopic view of a leadframe of the package structure 10. FIG. 3 is a top view of a leadframe of the package structure 10.

As shown in FIGS. 5 and 2, the package structure 10 includes a leadframe 12 including a first portion 14 and a second portion 16 opposite to the first portion 14. The first portion 14 includes a first base part 18a and a plurality of first extended parts 18b, for example two first extended parts 18b, connected to the first base part 18a. The second portion 16 includes a second base part 20a and a plurality of second extended parts 20b, for example two second extended parts 20b, connected to the second base part 20a. In accordance with various product requirements, the number of extended parts may vary in the present invention, for example there may be three, four, or more, as long as there are at least two. The first extended parts 18b and the second extended parts 20b are arranged in such a way that they alternate with each other. In the package structure 10, a chip 22 is disposed on a part of the first extended parts 18b of the first portion 14 and the second extended parts 20b of the second portion 16 of the leadframe 12. In some embodiments, the chip 22 includes power components, for example high-power components.

In some embodiments, the leadframe 12 is made of metal, such as copper or another appropriate metal material. In FIG. 2, the first portion 14 and the second portion 16 are comb-like structures. The first extended parts 18b of the first portion 14 extend towards the second base part 20a of the second portion 16. The second extended parts 20b of the second portion 16 extend towards the first base part 18a of the first portion 14. The first extended parts 18b of the first portion 14 and the second extended parts 20b of the second portion 16 are coplanar.

In FIG. 2, there is a first distance S1 between the first extended part 18b of the first portion 14 and the second base part 20a of the second portion 16. There is a second distance S2 between the first base part 18a of the first portion 14 and the second base part 20a of the second portion 16. In some embodiments, the second distance S2 is greater than or equal to about three times the first distance S1. In some embodiments, the first distance S1 is in a range from about 100µm to about 500µm. Similarly, there is a first distance S1' between the second extended part 20b of the second portion 16 and the first base part 18a of the first portion 14. The second distance S2 is greater than or equal to about three times the first distance S1'. In some embodiments, the first distance S1' is in a range from about 100µm to about 500µm.

In FIG. 2, the first extended part 18b of the first portion 14 and the second extended part 20b of the second portion 16 have a first thickness T1. The first base part 18a of the first portion 14 and the second base part 20a of the second portion 16 have a second thickness T2. In some embodiments, the second thickness T2 is greater than or equal to about two times the first thickness T1. In some embodiments, the difference between the second thickness T2 and the first thickness T1 is greater than or equal to about 100µm. In some embodiments, the second thickness T2 is in a range from about 200µm to about 400µm.

Referring to FIG. 3, the first extended part 18b has a length L and a width W, and the length L is greater than or equal to about three times the width W. Similarly, the second extended part 20b has a length L' and a width W', and the length L' is greater than or equal to about three times the width W'. In FIG. 3, the first extended part 18b and the second extended part 20b are in the shape of a rectangle.

In some embodiments, the first extended part 18b and the second extended part 20b being another appropriate shape, such as the shape of trapezoid, is also applicable in the present invention, as shown in FIG. 4. In FIG. 4, the first extended part 18b of the first portion 14 has a bottom portion 24a connected to the first base part 18a and a top portion 24b towards the second base part 20a of the second portion 16. The first extended part 18b has a width W which decreases gradually from the bottom portion 24a to the top portion 24b of the first extended part 18b. The first extended part 18b of the first portion 14 has a length L and an average width Wav, and the length L is greater than or equal to about three times the average width Wav. Similarly, the second extended part 20b of the second portion 16 has a bottom portion 26a connected to the second base part 20a and a top portion 26b towards the first base part 18a of the first portion 14. The second extended part 20b has a width W' which decreases gradually from the bottom portion 26a to the top portion 26b of the second extended part 20b. The second extended part 20b of the second portion 16 has a length L' and an average width Wav', and the length L' is greater than or equal to about three times the average width Wav'.

In FIG. 5, the chip 22 is disposed on a part of the first extended parts 18b of the first portion 14 and the second extended parts 20b of the second portion 16 via copper pillars 34. In FIG. 5, the copper pillars 34 are first formed on the chip 22 by, for example electroplating. The reverse chip 22 is then attached on the first extended parts 18b of the first portion 14 and the second extended parts 20b of the second portion 16 by the copper pillars 34 using the flip chip technology.

In FIG. 5, in some embodiments, a part of the first base part 18a of the first portion 14 further extends towards the second base part 20a of the second portion 16 to form an extending portion 18a' which is under a part of the first extended part 18b of the first portion 14. In FIG. 5, there is a third distance S3 between the extending portion 18a' of the first base part 18a of the first portion 14 and the second base part 20a of the second portion 16. In some embodiments, the third distance S3 is greater than or equal to about three times the first distance S1.

In FIG. 5, the package structure 10 further includes an encapsulation material 30 covering the chip 22 and a part of the leadframe 12, exposing sidewalls 32a and bottoms 32b of the first base part 18a of the first portion 14 and the second base part 20a of the second portion 16 of the leadframe 12.

Referring to FIGS. 6, 2 and 3, in accordance with one embodiment of the invention, a package structure 10 is provided. FIG. 6 is a cross-sectional view of the package structure 10. FIG. 2 is a stereoscopic view of a leadframe of the package structure 10. FIG. 3 is a top view of a leadframe of the package structure 10.

As shown in FIGS. 6 and 2, the package structure 10 includes a leadframe 12 including a first portion 14 and a second portion 16 opposite to the first portion 14. The first portion 14 includes a first base part 18a and a plurality of first extended parts 18b, for example two first extended parts 18b, connected to the first base part 18a. The second portion 16 includes a second base part 20a and a plurality of second extended parts 20b, for example two second extended parts 20b, connected to the second base part 20a. In accordance with various product requirements, the number of extended parts may vary in the present invention, for example there may be three, four, or more, as long as there are at least two. The first extended parts 18b and the second extended parts 20b are arranged in such a way that they alternate with each other. In the package structure 10, a chip 22 is disposed on a part of the first extended parts 18b of the first portion 14 and the second extended parts 20b of the second portion 16 of the leadframe 12. In some embodiments, the chip 22 includes power components, for example high-power components.

In some embodiments, the leadframe 12 is made of metal, such as copper or another appropriate metal material. In FIG. 2, the first portion 14 and the second portion 16 are comb-like structures. The first extended parts 18b of the first portion 14 extend towards the second base part 20a of the second portion 16. The second extended parts 20b of the second portion 16 extend towards the first base part 18a of the first portion 14. The first extended parts 18b of the first portion 14 and the second extended parts 20b of the second portion 16 are coplanar.

In FIG. 2, there is a first distance S1 between the first extended part 18b of the first portion 14 and the second base part 20a of the second portion 16. There is a second distance S2 between the first base part 18a of the first portion 14 and the second base part 20a of the second portion 16. In some embodiments, the second distance S2 is greater than or equal to about three times the first distance S1. In some embodiments, the first distance S1 is in a range from about 100µm to about 500µm. Similarly, there is a first distance S1' between the second extended part 20b of the second portion 16 and the first base part 18a of the first portion 14. The second distance S2 is greater than or equal to about three times the first distance S1'. In some embodiments, the first distance S1' is in a range from about 100µm to about 500µm.

In FIG. 2, the first extended part 18b of the first portion 14 and the second extended part 20b of the second portion 16 have a first thickness T1. The first base part 18a of the first portion 14 and the second base part 20a of the second portion 16 have a second thickness T2. In some embodiments, the second thickness T2 is greater than or equal to about two times the first thickness T1. In some embodiments, the difference between the second thickness T2 and the first thickness T1 is greater than or equal to about 100µm. In some embodiments, the second thickness T2 is in a range from about 200µm to about 400µm.

Referring to FIG. 3, the first extended part 18b has a length L and a width W, and the length L is greater than or equal to about three times the width W. Similarly, the second extended part 20b has a length L' and a width W', and the length L' is greater than or equal to about three times the width W'. In FIG. 3, the first extended part 18b and the second extended part 20b are in the shape of a rectangle.

In some embodiments, the first extended part 18b and the second extended part 20b being another appropriate shape, such as the shape of trapezoid, is also applicable in the present invention, as shown in FIG. 4. In FIG. 4, the first extended part 18b of the first portion 14 has a bottom portion 24a connected to the first base part 18a and a top portion 24b towards the second base part 20a of the second portion 16. The first extended part 18b has a width W which decreases gradually from the bottom portion 24a to the top portion 24b of the first extended part 18b. The first extended part 18b of the first portion 14 has a length L and an average width Wav, and the length L is greater than or equal to about three times the average width Wav. Similarly, the second extended part 20b of the second portion 16 has a bottom portion 26a connected to the second base part 20a and a top portion 26b towards the first base part 18a of the first portion 14. The second extended part 20b has a width W' which decreases gradually from the bottom portion 26a to the top portion 26b of the second extended part 20b. The second extended part 20b of the second portion 16 has a length L' and an average width Wav', and the length L' is greater than or equal to about three times the average width Wav'.

In FIG. 6, the chip 22 is disposed on a part of the first extended parts 18b of the first portion 14 and the second extended parts 20b of the second portion 16 via solder paste 36. In FIG. 6, the solder paste 36 is first formed on the first extended parts 18b of the first portion 14 and the second extended parts 20b of the second portion 16 by, for example screen printing. The reverse chip 22 is then attached on the first extended parts 18b of the first portion 14 and the second extended parts 20b of the second portion 16 by the solder paste 36 using the flip chip technology. In some embodiments, other appropriate conductive materials, such as silver paste, are also applicable in the present invention.

In FIG. 6, in some embodiments, a part of the first base part 18a of the first portion 14 further extends towards the second base part 20a of the second portion 16 to form an extending portion 18a' which is under a part of the first extended part 18b of the first portion 14. In FIG. 6, there is a third distance S3 between the extending portion 18a' of the first base part 18a of the first portion 14 and the second base part 20a of the second portion 16. In some embodiments, the third distance S3 is greater than or equal to about three times the first distance S1.

In FIG. 6, the package structure 10 further includes an encapsulation material 30 covering the chip 22 and a part of the leadframe 12, exposing sidewalls 32a and bottoms 32b of the first base part 18a of the first portion 14 and the second base part 20a of the second portion 16 of the leadframe 12.

In the present invention, a package structure with a specific comb-like leadframe is provided. Some appropriate dimensions and structure configurations of the leadframe are considered. For example, the distance between the first base part and the second base part is greater than or equal to about three times the distance between the first extended part and the second base part, or the thickness of the base part is greater than or equal to about two times the thickness of the extended part, or the extended part has the shape of trapezoid. When the distance between the first extended part and the second base part is less than 100µm, the insulation distance is insufficient. When the distance between the first extended part and the second base part is greater than 500µm, the size of the chip will exceed the range of the extended part, affecting the current conduction. When the thickness of the extended part is too thick, there is a risk of exposing the extended parts from the encapsulation material. In addition, the trapezoidal extended part improves the uniformity of the current conduction. When current is collected along the chip, it is no longer conducted only through the metal structure in the chip, but is the "extended part" combined with the metal structure. The total cross-sectional area for current conduction is increased by disposing the chip on the extended parts protruding from the base part of the comb-like leadframe which further increases the carrying current. The increase of the cross-sectional area also reduces the resistance value simultaneously, so that when the current flows through it, the voltage difference generated is reduced, achieving uniform and stable current density and voltage during component operation.

While the invention has been described by way of example and in terms of embodiment, it is to be understood that the invention is not limited thereto. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A package structure (10), comprising:
a leadframe (12) comprising a first portion (14) and a second portion (16) opposite to the first portion (14), wherein the first portion (14) comprises a first base part (18a) and a plurality of first extended parts (18b) connected to the first base part (18a), the second portion (16) comprises a second base part (20a) and a plurality of second extended parts (20b) connected to the second base part (20a), and the first extended parts (18b) and the second extended parts (20b) are arranged in such a way that they alternate with each other; and
a chip (22) disposed on a part of the first extended parts (18b) of the first portion (14) and the second extended parts (20b) of the second portion (16) of the leadframe (12).

2. The package structure as claimed in claim 1, wherein the first portion (14) and the second portion (16) are comb-like structures.

3. The package structure as claimed in claim 2, wherein the first extended parts (18b) of the first portion (14) extend towards the second base part (20a) of the second portion (16), and the second extended parts (20b) of the second portion (16) extend towards the first base part (18a) of the first portion (14).

4. The package structure as claimed in claim 3, wherein the first extended parts (18b) of the first portion (14) and the second extended parts (20b) of the second portion (16) are coplanar.

5. The package structure as claimed in claim 4, wherein there is a first distance (S1) between the first extended part (18b) of the first portion (14) and the second base part (20a) of the second portion (16).

6. The package structure as claimed in claim 5, wherein there is a second distance (S2) between the first base part (18a) of the first portion (14) and the second base part (20a) of the second portion (16).

7. The package structure as claimed in claim 6, wherein the second distance (S2) is greater than or equal to three times the first distance (S1).

8. The package structure as claimed in any of the claims 5 to 7, wherein the first distance (S1) is in a range from 100µm to 500µm.

9. The package structure as claimed in any of the claims 1 to 8, wherein the first extended part (18b) of the first portion (14) and the second extended part (20b) of the second portion (16) have a first thickness (T1).

10. The package structure as claimed in claim 9, wherein the first base part (18a) of the first portion (14) and the second base part (20a) of the second portion (16) have a second thickness (T2).

11. The package structure as claimed in claim 10, wherein the second thickness (T2) is greater than or equal to two times the first thickness (T1).

12. The package structure as claimed in any of the claims 1 to 11, wherein the first extended part (18b) of the first portion (14) has a bottom portion (24a) connected to the first base part (18a) and a top portion (24b) towards the second base part (20a) of the second portion (16), and the first extended part (18b) has a width (W) which decreases gradually from the bottom portion (24a) to the top portion (24b) of the first extended part (18b).

13. The package structure as claimed in any of the claims 5 to 12, wherein a part of the first base part (18a) of the first portion (14) further extends towards the second base part (20a) of the second portion (16) to a position which is under a part of the first extended part (18b) of the first portion (14).

14. The package structure as claimed in claim 13, wherein there is a third distance (S3) between the first base part (18a) of the first portion (14) and the second base part (20a) of the second portion (16).

15. The package structure as claimed in any of the claims 1 to 14, further comprising an encapsulation material (30) covering the chip (22) and a part of the leadframe (12), exposing sidewalls (32a) and bottoms (32b) of the first base part (18a) of the first portion (14) and the second base part (20a) of the second portion (16) of the leadframe (12).
